# EUROPEAN PATENT SPECIFICATION

(11) **EP 0 561 847 B1**
(45) Date of publication and mention of the grant of the patent: **27.08.1997**
(21) Application number: 91920857.9
(22) Date of filing: 06.12.1991
(51) Int. Cl.: C08G 63/685, G03F 7/021, C08G 59/58

(54) **PHOTOSENSITIVE POLYMERS AND PRINTING PLATES**
LICHTEMPFINDLICHE POLYMERE UND DRUCKPLATTE
POLYMERES PHOTOSENSIBLES ET PLAQUES D'IMPRESSION

(30) Priority: 13.12.1990 IT 2237390
(43) Date of publication of application: 29.09.1993
(73) Proprietor: LASTRA S.P.A., I-25025 Manerbio (IT)
(72) Inventor: CANESTRI, Giuseppe, I-47037 Rimini (IT); DE CANDIDO, Stefano, I-33050 Teor (IT)
(74) Representative: Marchi, Massimo, Dr.
(86) International application number: EP9102349
(87) International publication number: WO9210523

(56) References cited:
- DE-A- 1 934 532
- FR-A- 2 101 639
- US-A- 3 544 317
- CHEMICAL ABSTRACTS, vol. 86, no. 10, 7 March 1977, Columbus, Ohio, US; abstract no. 56372R, page 52

## Description

The present invention relates to new polymers and presensitized positive and negative offset printing plates.

More particularly, it relates to polymers suitable to form, when mixed to diazonium salts and photoinitiators, a photosensitive composition suitable to produce presensitized positive and negative offset printing plates having improved properties.

It is known that the properties required to a polymer for the production of presensitized positive and negative offset printing plates are:
- good compatibility with diazonium salts;
- good stability of the photosensitive mixture (i.e. polymer plus diazonium salt);
- good adhesion of the photosensitive mixture to the support;
- high difference of solubility in aqueous developing solutions between light exposed and non-exposed areas;
- high development speed; i.e., when eposed for the same time to a lamp having an emission spectrum comprised within 200 to 500 nm, the complete elimination of the non-exposed photosensitive mixture should be as quick as possible;
- high ink retention of the mixture hardened upon exposition to a lamp having an emission spectrum comprised within 200 and 500 nm;
- high retention degree of the ink by the hardened mixture;
- high mechanical resistance of the hardened mixture.

It is also known that up to now several polymers have been prepared in order to find a polymer having all the above mentioned properties at the highiest possible degree. Examples of said polymers are disclosed in the following documents : US-4,289,838, US-4,316,949, UK-1,358,922, UK-1,463,818, UK-1,474,073, UK-A-2,057,704 and EP-A-182,642.

However, none of the known polymers is characterized by the optimization of the above mentioned properties. More particularly, polymers having a high development speed tend to have poor mechanical resistance, and vice versa. On the other hand, these two properties are known to the artisan to be critical for an economical industrial use of presensitized positive and negative offset printing plates.

It has now been found that the above properties may be optimized by means of a compound of the formula 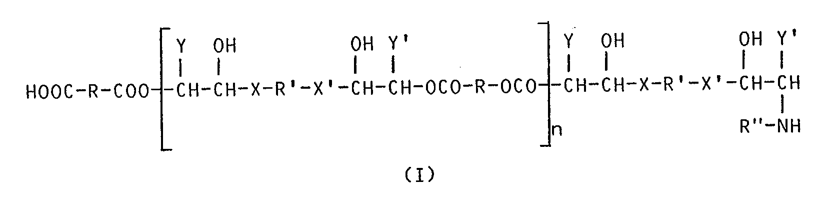 wherein
- R: is an aliphatic chain having from 2 to 6 carbon atoms and 1 or 2 double bonds;
- R': is a covalent bond, a divalent cycloalkyl group having from 5 to 6 carbon atoms, a saturated aliphatic chain having from 2 to 10 carbon atoms and 2 or 4 oxygen atoms which are part of -CO-O- groups, a saturated aliphatic chain having from 2 to 10 carbon atoms and 1 or 2 oxygen atoms of ether groups, a divalent saturated heterocyclic ring having from 3 to 4 carbon atoms and 2 oxygen atoms, a group of the formula 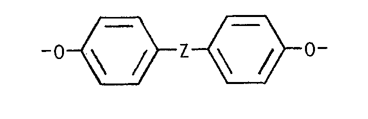 where
- Z: is SO₂, a saturated straight or branched alkyl chain having from 1 to 3 carbon atoms or an alkylidenephenyl group where the alkylidene moiety is saturated, straight or branched and has 1 to 3 carbon atoms;
- R": is a group of the formula 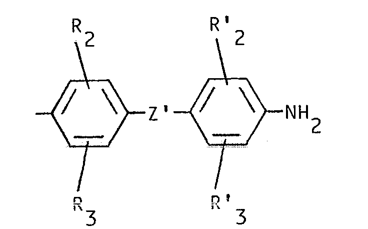 wherein
Z' is a covalent bond, O, S, CH₂, CO, NH, SO₂, SO₂NH, CH₂=CH₂, N=N, NHCONH, NHCSNH or CH₃-C-CH₃, and
R₂, R'₂, R₃,and R'₃, the same or different, are H, CH₃, OCH₃, OC₂H₅, Cl, SO₃H or CH₂-O-CH₃;
Y and Y', the same or different, are hydrogen or, together with X and X', respectively, complete a cycloaliphatic ring having from 5 to 6 carbon atoms; and
X and X' are CH₂ or, the same or different, are a covalent bond when Y and Y' respectively, are hydrogen or, together with Y and Y', respectively, complete a cycloaliphatic ring having from 5 to 6 carbon atoms; and
n is an integer from 2 to 60.

Preferably, the polymer according to the present invention has a weight average molecular weight value of from 1,200 to 33,000, an amine number (mg HCl/g polymer) of from 1 to 27, and an unsaturation equivalent (milliequivalents of Br₂/g) of from 400 to 560.

Preferred meanings of R are:
-CH=CH-CH=CH-, -CH₂-CH=CH-CH₂-, 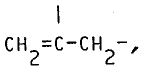 -CH=CH- and -CH=C(CH₃)-

Preferably R' is a covalent bond (ERL-4206 Union Carbide), -COOCH₂ (ERL-4221 Union Carbide), 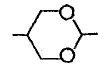 (ERL-4234 Union Carbide), CH₂-OCO-C₄H₈-COO-CH₂- (ERL-4299 Un. Carb.), or 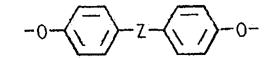 where Z is 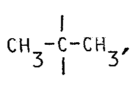 SO₂, CH₂, or

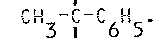

In comparison with the polymers of the state of the art, the compounds of formula (I) have the advantage of producing presensitized positive and negative offset printing plates having both high development speed and high mechanical resistance. Moreover, they are also endowed with high adhesivity to the substrate and this implies the advantage of requiring a lower graining of the support and a lower thickness of the photosensitive layer.

A second object of this invention is to provide a process for preparing a polymer of the formula I. Said process essentially consists of preparing an unsaturated polyhydroxypolyester having an epoxy end group and condensing said epoxy end group with an amino group of a suitable aromatic diamine according to the following scheme: 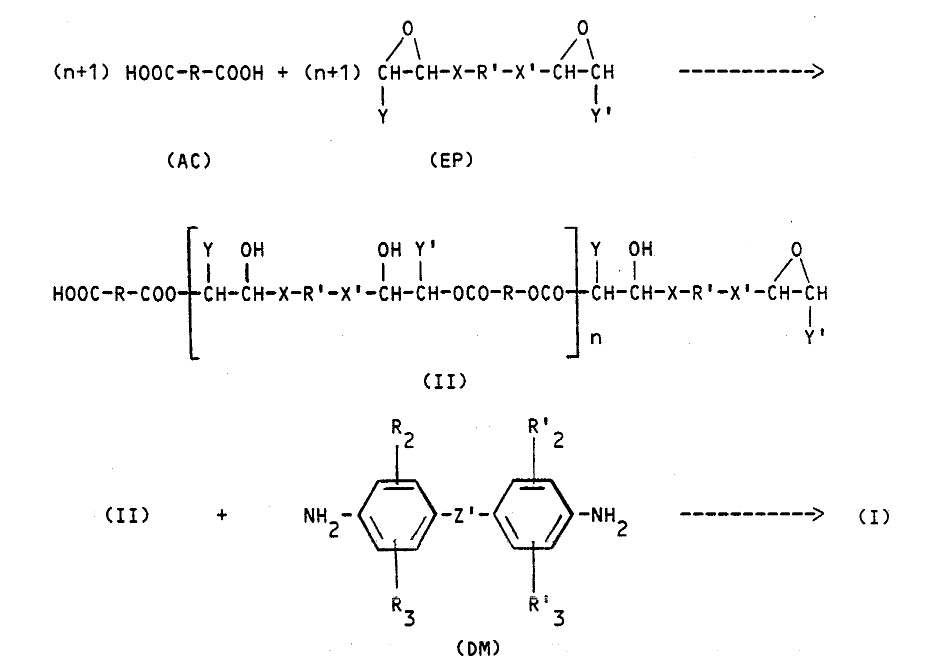 where n,R,Y,X,R',Z',R₂,R'₂,R₃,R'₃, have the meanings mentioned above in relation to the formula (I).

Preferred meanigs of (AC) are the following unsaturated aliphatic dicarboxylic acids : maleic, fumaric, muconic, hydromuconic, itaconic, citraconic and mesaconic.

Preferred meanings of (EP) are the followig diepoxides: vinyl cyclohexene dioxide (ERL-4206 Union Carbide), 3,4-epoxycyclohexylmethyl-3,4-epoxy-cyclohexane-carboxylate (ERL-4221 Union Carbide), 2-(3,4-epoxycyclohexyl-5,5-spiro-3,4-epoxy)-cyclohexane-metadioxane (ERL-4234 Union Carbide), bis(3,4-epoxycyclohexyl)-adipate (ERL-4299 Un.Carb.), and diglycidyl ethers of bisphenol A, S, ACP, and F.

The first reaction step, which relates to the preparation of the unsaturated polyhydroxy polyester (II), is preferably carried out by reacting substantially equimolar amounts of (AC) and (EP) in the presence of a suitable accelerating agent at a temperature of from 10 to 150°C, optionally in the presence of one or more suitable inert solvents, until the acidity number of the intermediate product (II) reaches the theoretical value calculated for the desired molecular weight.

Examples of suitable accelerating agents are AMC1 and AMC2 by Aerojet Strategic Propulsion (chromium salt soluble in organic solvents), p-toluensulphonic acid, triphenylphosphine, and trimethylammonium bromide.

Examples of suitable organic solvents are butyl acetate, methyl cellosolve, phenyl cellosolve, ethylene glycol dimethyl ether, and ethyl acetate.

The second reaction step comprises the addition of the aromatic diamine (DM) to the intermediate product (II). Said step is preferably performed by adding to the reaction mixture resulting from the first step an amount of (DM) substantially sufficient to react with the epoxy end groups of intermediate (II) at a temperature of from 50 to 150°C.

The running of the reaction is monitored by means of known analytical techniques (spectrophotometry FTIR and/or primary amine number).

At the end of the reaction it is preferred not to remove the solvents and to stabilize the polymer (I) toward oxidation by adding small amounts of known antioxidant agents such as, for example, hydroquinone, 2,6-di-terbutyl-p.cresole, butyraldoxime, 1,5-naphthalenediol, di-hydroxyazobenzene, 2-mercaptobenzothiazole, and the like.

A further object of this invention is to provide a presensitized positive or negative offset printing plate formed by a layer sensitive to the light having wavelength of from 200 to 500 nm spread on a suitable support, said photosensitive layer comprising essentially a polymer, a photosensitive diazocompound, a dye and a compound selected from photoinitiators, sensitizers, and diazides, characterized in that the polymer is a compound of the formula (I).

The support is preferably a metal sheet, e.g. aluminium, suitably treated according to known techniques such as degreasing, pickling, graining, buffing, electrochemical anodization, surface protection treatments and the like. Examples of said treatments are disclosed by the patents US-2,882,153, US-2,882,154, US-2,946,683, US-3,160,506, US-3,330,743, US-3,440,050, US-3,891,516, US-3,963,594, US-4,072,589, UK-1,235,863, UK-1,544,315, DE-907,147, DE-1,160,733.

In general, the diazocompounds present in photosensitive compositions according to the present invention are consisting of positive or negative light-sensitive diazocompounds commonly used for lithographic printing plates. Preferably, these compounds are aromatic diazocompounds wich have been condensed with products containing reactive carbonyl groups such as formaldehyde and paraformaldehyde. Said diazocompounds may be reacted with copulating agents such as, e.g., aromatic acid compounds such as benzenesulphonate, toluenesulphonate, unsubstituted or substituted sulphonated benzophenones. Examples of these diazocompounds are disclosed by the following patents: US-2,922,715, US-2,946,683, US-3,300,309, US-3,591,575, US-3,113,865, US-3,661,573, US-3,050,502, US-3,311,605, US-3,163,633, UK-1,277,428, EP-A-74,580 and EP-135,616.

In turn, examples of photoinitiators, photosensitizers and diazides are disclosed by the patents UK-1,482,953, US-3,954,475, US-4,059,400, US-4,058,401, US-3,775,113, US-3,887,450, US-3,895,949, US-4,043,819, US-3,046,120, US-3,046,121 and US-3,211,553.

The addition of a dye has substantially the aim of enabling to visualize the non-exposed portions with respect to those exposed to a lamp having an emission spectrum coprised within 200 and 500 nm. Usually, it is preferably used any known dye that is compatible with the other components of the photosensitive layer and is easily removable by the developing bath from the non-exposed portions.

Several kinds of developing products, also called "developers", have been tested in the development tests performed on the printing plates of this invention. The developers having the following percent composition (w/w) are cited among those which proved to better remove, after exposure to the actinic light, the non printing portions:

| | | |
|---|---|---|
| alkylsulphonate (or alkylbenzenesulphonate) | 5.0 | 13.0 |
| ethylene glycol monophenylether | 3.0 | 8.0 |
| sodium metasilicate pentahydrate | 0.6 | 1.2 |
| deionized water | 91.4 | 77.8 |
| | 100.0 | 100.0 |

Dodecyl-, decyl-, nonyl-, and octylbenzenesulphonate, dodecyl-, decyl-, nonyl-, and octylsulphonate of organic and inorganic bases, and the mixture thereof are examples of suitable alkyl- and alkylbenzene-sulphonates. Typical examples of suitable organic and inorganic bases are: triethanolamine, sodium, potassium and lithium.

A specific example of a suitable developing composition comprises: 1,000 g of Sulfetal TL 40™ by Zschimmer & Schwarz, 600 g of phenyl glycol by BASF, 100 of sodium metasilicate pentahydrate by A.C.E.F. (Italy), and 2,300 of deionized water.

The following examples illustrates the invention without, however, limiting it in any way.

### EXAMPLES 1-20

### Polymers of the Invention

210.2 g of muconic acid (1.0 moles), 366.2 g of bis-(3,4-epoxycyclohexyl)-adipate (1.0 moles) and 290.4 g of butyl acetate (2.5 moles) were placed in a 2-litres reactor equipped with stirrer, electric heating jacket, thermometer, electric thermostat and double jacket condensing coil.

The mixture was stirred at room temperature for 5 minutes and then brought to 80°C. Upon reaching 80°C, 6.68 g of AMC-2 (0.04 moles), catalyst consisting of an organic chromium salt manufactured by Aerojet Strategic Propulsion Co. U.S.A, diluted in 58.1 g of butyl acetate (0.5 moles), were added in about 30 minutes. The temperature was then raised to 100°C and maintained until the acid number of the product was of 20 mg KOH/g. 91.3 g of methylcellosolve (1.2 moles) were then added and the temperature was reduced very qickly to 50°C. The acid number of the thus obtained product was of 18 mg KOH/g and the weight average molecular weight value of 16,000. 19.4 g of 4,4'-diaminodiphenylmethane (0.01 moles) were added and the temperature was raised to 80°C and maintained until 50% reduction of the primary amine absorption band (FTIR spectrophotometer). At the end of the reaction, 2.20 g of hydroquinone (0.02 moles) were added in order to stabilize the product toward oxidation.

All polymers (P) listed in table I were prepared in a similar way, using the same solvents, the same catalyst and the same molar ratios (1.0 moles of unsaturated dicarboxylic acid, 1.0 moles of diepoxide, 0.1 moles of diamine); the codes listed in table I identify the following starting materials:

### Unsaturated dicarboxylic acids (AC)

- AC-0 :: muconic acid
- AC-1 :: hydromuconic acid
- AC-2 :: itaconic acid

### diepoxides (EP)

- EP-0 :: bis-(3,4 epoxycyclohexyl)adipate (ERL-4299 Union Carbide)
- EP-1 :: bisphenol A diglycidyl ether
- EP-2 :: bisphenol S diglycidyl ether
- EP-3 :: bisphenol ACP diglycidyl ether
- EP-4 :: bisphenol F diglycidyl ether
- EP-5 :: 3,4-epoxycyclohexylmethyl-3,4-epoxycylohexane-carboxylate (ERL-4221 Union Carbide)
- EP-6 :: vinylcyclohexene dioxide (ERL-4206 Union Carbide)
- EP-7 :: 2-(3,4-epoxycyclohexyl-5,5-spiro-3,4-epoxycyclohexane-metadioxane (ERL-4234 Union Carbide)

### diamines (DM)

- DM-0 :: 4,4'-diamine-diphenylmethane
- DM-1 :: 4,4'-diamine-diphenylsulphone
- DM-2 :: benzidine
- DM-4 :: 2,2'-dichloro-5,5'-dimethoxybenzidine
- DM-6 :: 5-amino-2-(p-aminoaniline)-benzenesulphonic acid
- DM-7 :: 5-amino-2-(4-amino-m-toluidine)-benzenesulphonic acid
- DM-8 :: 4,4'-isopropylidenedianiline
- DM-10 :: 4,4'-diaminodiphenylamine
- DM-12 :: 6,6'-thiodimetanilic acid
- DM-13 :: 4,4'-diamino-carbanilide
- DM-15 :: C.I. Disperse Black 2 (C.I. 11255)
- DM-16 :: Bistramine Brown G (C.I. 11275)
- DM-17 :: Cellitazol BGL (C.I. 11245)

**TABLE I**

| EXAMPLE No. | POLYMER No | AC | EP | DM |
|---|---|---|---|---|
| 1 | P1 | AC-0 | EP-0 | DM-0 |
| 2 | P2 | AC-1 | EP-1 | DM-1 |
| 3 | P3 | AC-2 | EP-2 | DM-4 |
| 4 | P4 | AC-0 | EP-3 | DM-6 |
| 5 | P5 | AC-1 | EP-4 | DM-7 |
| 6 | P6 | AC-2 | EP-0 | DM-8 |
| 7 | P7 | AC-0 | EP-1 | DM-10 |
| 8 | P8 | AC-1 | EP-2 | DM-12 |
| 9 | P9 | AC-2 | EP-3 | DM-16 |
| 10 | P10 | AC-0 | EP-4 | DM-17 |
| 11 | P11 | AC-0 | EP-5 | DM-0 |
| 12 | P12 | AC-1 | EP-6 | DM-2 |
| 13 | P13 | AC-2 | EP-7 | DM-4 |
| 14 | P14 | AC-0 | EP-5 | DM-6 |
| 15 | P15 | AC-1 | EP-6 | DM-8 |
| 16 | P16 | AC-2 | EP-5 | DM-10 |
| 17 | P17 | AC-0 | EP-6 | DM-11 |
| 18 | P18 | AC-1 | EP-7 | DM-13 |
| 19 | P19 | AC-2 | EP-5 | DM-15 |
| 20 | P20 | AC-0 | EP-6 | DM-17 |

### EXAMPLE 21

### Comparison Products

In the tests described below, the polymers prepared according to examples No. 1-20 were also compared with the following commercial products:
- PA :: C.A.P. (cellulose acetophthalate), Eastman Kodak
- PB :: Macrynal^{(R)} SM 510 N/21 modified with maleic anhydride in molar ratio 1:0.12. Macrynal SM 510 N/21 is an acrylic polycondensate (60% in methyl acetate) by Hoechst.
- PC :: Movital^{(R)} B 60 T modified with maleic anhydride in molar ratio 1:0.12. Movital B 60 T is a terpolymer from vinyl butyral/vinyl acetate/vinyl alcohol (71/2/27 parts by weight) by Hoechst.
- PD :: Formvar^{(R)} 12/85T modified with maleic anhydride in molar ratio 1:0.12. Formvar 12/85T is a condensate from polyvinyl alcohol/formaldehyde by Monsanto.

### EXAMPLES 22-74

### Photosensitive Composition and Printing Plate

The photosensitive composition of this invention mainly comprises the following ingredients:

| | | Parts (w/w) |
|---|---|---|
| (P) | polymer of the formula (I) according to this invention | 68.5-74.0 |
| (DZ) | diazo compound | 20.0-12.0 |
| (CO) | dye | 2.5- 3.0 |
| (FO) | photoinitiator or | |
| (SE) | sensitizer or | |
| (ZD) | diazide | 6.5-8.0 |
| (LI) | levelling agent | 2.3- 3.0 |

dissolved in 1,500-1,700 parts of a diluent mixture or in a non-aqueous and non-reactive diluent.

The expression "non-reactive diluents" is intended to mean all those diluents which cannot undergo reaction under the action of light beams having a wavelenght of from 180 to 550 nanometers or heat to form polymers or condensates.

The codes listed in table II identify the following ingredients:

### Polymers (P)

- polymers (P1-P20) of examples 1-20
- comparison products (PA, PB, PC, and PD)
- polymer (P21) disclosed in example No.21

### Diazonium salts (DZ)

having the following general formula: 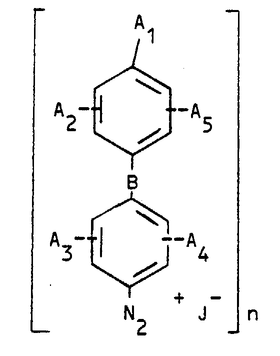 are identified as follows:
- DZ-0 :: A₁=A₂=A₃=A₄= H, A₅= -CH₂-, B = NH, n = 1-6
J = p-toluenesulphonate
- DZ-1 :: A₁=A₂=A₃=A₄=H, A₅=-CH₂-,B = NH, n = 1-6
J = 2-hydroxy-4-methoxy-benzophenonesulphonate
- DZ-2 :: A₁=A₂=A₄= H, A₃= OCH₃, A₅ = 4,4'-oxymethanediphenylether
B = NH, n = 1-6, J = p-toluenesulphonate
- DZ-3 :: A₁ = -N(CH₃)₂, A₂=H, A₃=A₄= OCH₃,
A₅= 4,4'-oxymethanediphenylether, B = NH, n = 1-6,
J = 2-hydroxy-4-methoxy-benzophenone-5-sulphonate
- DZ-4 :: A₁= OH, A₂=A₃=A₄= H, A₅= 4,4'-oxymethanediphenylether
B = -CH=CH-, n = 1-6, J = p-toluenesulphonate
- DZ-5 :: A₁=A₂=A₃= H, A₄= OCH₃, A₅= 4,4'-oxymethanediphenylether
B = -NH-CO-, n = 1-6,
J = 2-hydroxy-4-methoxybenzophenone-5-sulphonate
- DZ-6 :: A₁= N(CH₃)₂, A₂=A₃=A₄= H, A₅= benzene-1,4-oxymethane
B = -SO₂-, n = 1-6, J = p-toluenesulphonate
- DZ-7 :: A₁= N(CH₃)₂, A₂= H, A₃=A₄= OCH₃,
A₅= 4,4'-oxymethanediphenylether, B = -O-, n = 1-6,
J = 2-hydroxy-4-methoxybenzophenone-5-sulphonate
- DZ-8 :: A₁-A₂= H, A₃=A₄= OCH₃, A₄= CH₃,
A₅=dimethoxy-4,4'-oxymethanediphenylether, B = -S-,
n = 1-6, J = p-toluenesulphonate
- DZ-9 :: A₁=A₂= H, A₃=A₄= OC₂H₅, A₅= 4,4'-oxymethanediphenylether, B = -NH-CO-, n = 1-6, J = p-toluenesulphonate
- DZ-10 :: A₁=CH₃, A₂= H, A₃=A₄= OC₂H₅, A₅= 4,4'-oxymethanediphenylether, B = -S-, n = 1-6, J = p-toluenesulphonate
- DZ-11 :: A₁ = CH₃, A₂ = H, A₃=A₄ = OCH₃, A₅= 4,4'-oxymethanediphenylether, B = -S-, n = 1-6, J = p-toluenesulphonate

### Dye (CO)

- CO-0 :: Victoria Blue FB (BASF)
- CO-1 :: Victoria Blue FBO (BASF)
- CO-2 :: Duasyne (Hoechst)
- CO-3 :: Etasol BF Rosa Bengala (Colori Baglié)
- CO-4 :: Crystal Violet (BASF)
- CO-5 :: Methyl Violet (BASF)
- CO-6 :: Sudan Blue (BASF)

### Photoinitiators (FO)

- FO-0 :: Quantacure™ PDO (Ward Blankinsop & Co.)
- FO-1 :: Quantacure™ B1 " "
- FO-2 :: Quantacure™ B3 " "
- FO-3 :: Quantacure™ B4 " "
- FO-4 :: Quantacure™ B5 " "
- FO-5 :: Quantacure™ CTX " "
- FO-6 :: Quantacure™ MTX " "
- FO-7 :: Quantacure™ ITX " "
- FO-8 :: Quantacure™ DBS " "
- FO-9 :: Quantacure™ EPD " "
- FO-10 :: Quantacure™ EOB " "
- FO-11 :: Quantacure™ BEA " "
- FO-10 :: Quantacure™ EOB " "
- FO-12 :: Quantacure™ DMB " "
- FO-13 :: Darocur™ 1173 (Merck) A.G.
- FO-14 :: Darocur™ 1116 "
- FO-15 :: Darocur™ 1664 "
- FO-16 :: Irgacure™ 651 (Ciba-Geigy)

### Sensitizers (SE)

- SE-0 :: Acridine Orange
- SE-1 :: Acridine Yellow
- SE-2 :: Phosphine
- SE-3 :: Benzoflavine
- SE-4 :: Setoflavine
- SE-5 :: Michler's Ketone
- SE-6 :: 4-(methoxy)-benzylamino-2,5-diethoxybenzene diazo zinc chloride
- SE-7 :: p-N,N-dibutylaminobenzene diazo zinc chloride
- SE-8 :: 4-pyrrolidine-3-methylbenzene diazo tetrafluoborate
- SE-9 :: CH₃-C₆H₄-NH-C₆H₄-N₂ ⁺ .BF₄⁻
- SE-10:: 4-pyrrolidine-3-methoxybenzene diazo tetrafluoborate
- SE-11:: CH₃-C₆H₄-NH-C₆H₄ -N₂ ⁺.Cl.⁻ 1/2 ZnCl₂
- SE-12:: 4-(p-tolylmercapto)-2,5-diethoxybenzene diazo zinc chloride
- SE-13:: 4-(p-tolylmercapto)-2,5-diethoxybenzene diazo tetrafluoborate
- SE-14:: 4-(p-tolylmercapto)-2,5-dimethoxybenzene diazo zinc chloride
- SE-15:: 4-morpholino-2,5-dibutoxybenzene diazo zinc chloride
- SE-16:: 4-morpholino-2,5-dibutoxybenzene diazo tetrafluoborate
- SE-17:: morpholino-2,5-diethoxybenzene diazo zinc chloride
- SE-18:: morpholino-2,5-diethoxybenzene diazo tetrafluoborate

### Diazides (ZD)

- ZD-0 :: 4,4'-diazidodiphenylmethane
- ZD-1 :: diphenyldiazide
- ZD-2 :: dimethoxydiphenyldiazide
- ZD-3 :: p-aminodiphenyldiazide
- ZD-4 :: stilbenediazide
- ZD-5 :: azidostilbene benzoazide
- ZD-6 :: diazido distilbenephenone
- ZD-7 :: 2,6-bis-(4'-azidobenzylidene)-cyclohexanone

### Levelling agents (LI)

- LI-0 :: Fluorad™ FC 430 (3M)
- LI-1 :: Fluorad™ FC 431 (3M)

### Preparation of the Photosensitive Composition and Printing Plate

In a 2-liters glass vessel equipped with a stirrer having variable speed (60-2,500 r.p.m.) and a cooling jacket, 1,500 parts by weight of methylcellosolve and 18 parts by weight of a polydiazodiphenylamine paraformaldehyde condensate salified with p.toluensulphonic acid (DZ-0) were placed while stirring at 150 r.p.m., when the solution was clear 70 parts by weight of a dry polymer product of formula P1, prepared as disclosed in example No. 1, were added.

When the solution became again clear under stirring at 150 r.p.m., 6.5 parts by weight of Quantacure™ PDO (FO-0) were added; once obtained a clear solution, 3.0 parts of Victoria Blue FB (CO-0) were added under stirring and keeping the temperature below 30°C, 2.5 parts by weight of levelling agent Fluorad™ FC 430 (LI-0) were then added with stirring. The thus obtained product was uniformly coated by means of an automatic device, in the amount of 14.2 g/m², on an aluminium support of 2 m² having a thickness of 0.3 mm which had previously undergone the following treatments:
- alkaline cleaning and subsequent washing
- pickling with inorganic acids
- surface graining by electrochemical treatment and subsequent washing
- cleaning by an acid bath and subsequent washing
- anodizing by immersion in an acid bath under direct current
- surface treatment (0.2 g/m²) with sodium silicate of the formula Na₂SiO₃O₇ and subsequent washing
- additional protective treatment by an aqueous solution of polyvinylphosphonic acid (0.2 g/m²) and subsequent washing.

The thus obtained photosensitive printing plate was dried in an infrared oven, with forced ventilation, for 3 minutes at a temperature of 70°C. After cooling, the plate was stored in a dark place where the humidity degree was 60%, protected from air by means of a sealed polyethylene sheet.

After drying the final weight of the photosensitive coating composition was of 0.9 g/m².

By a similar way and using the same solvents, the photosensitive plates (L) listed in table II (plates 1-52) were prepared. The concentration of the ingredients used was as follows:
- 70: parts by weight of a polymer (P) according to Table I or comparison example No. 21 (P21) or of a comparison product (PA, PB, PC, PD), and
- 18: parts by weight of diazonium salts (DZ) for plates No. 1-24 and plate No.52, or
- 12: parts by weight of diazonium salts (DZ) for plates No. 25-52, and
- 6.5: parts by weight of sensitizer (SE), or photoinitiator (FO), or diazides (ZD),
- 3: parts by weight of dye (CO), and
- 2: parts by weight of the levelling agent Fluorad™ FC 430 (LI-O).

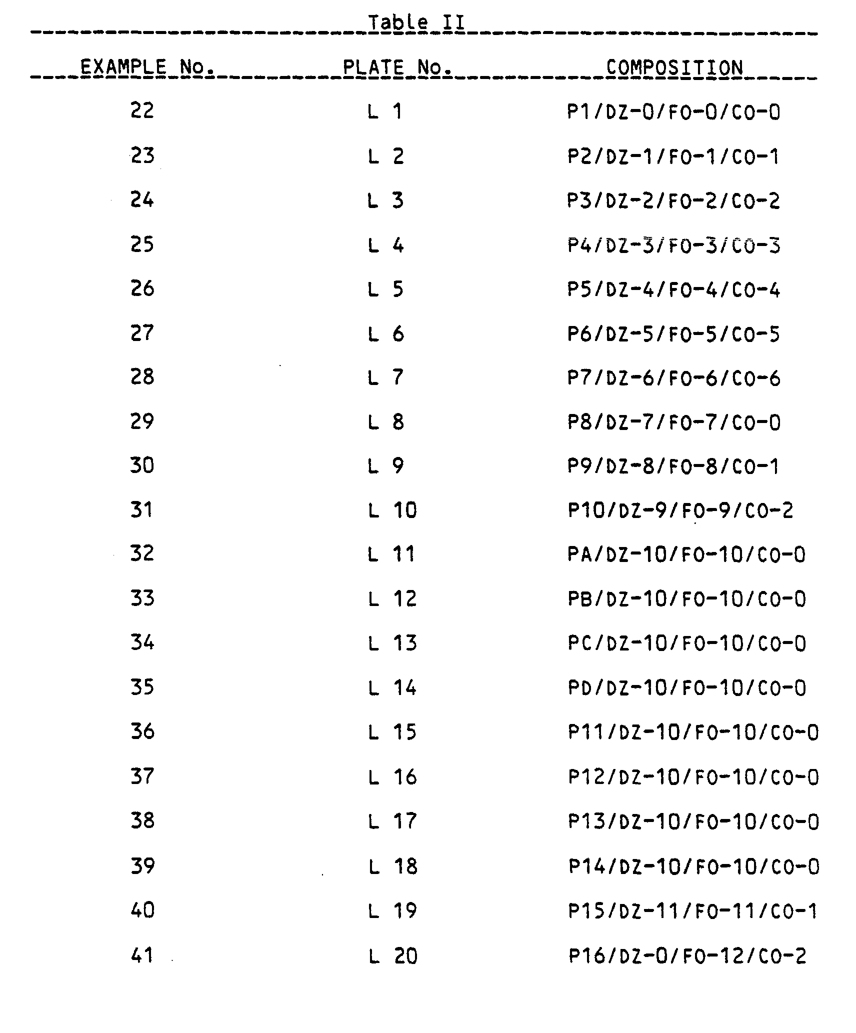

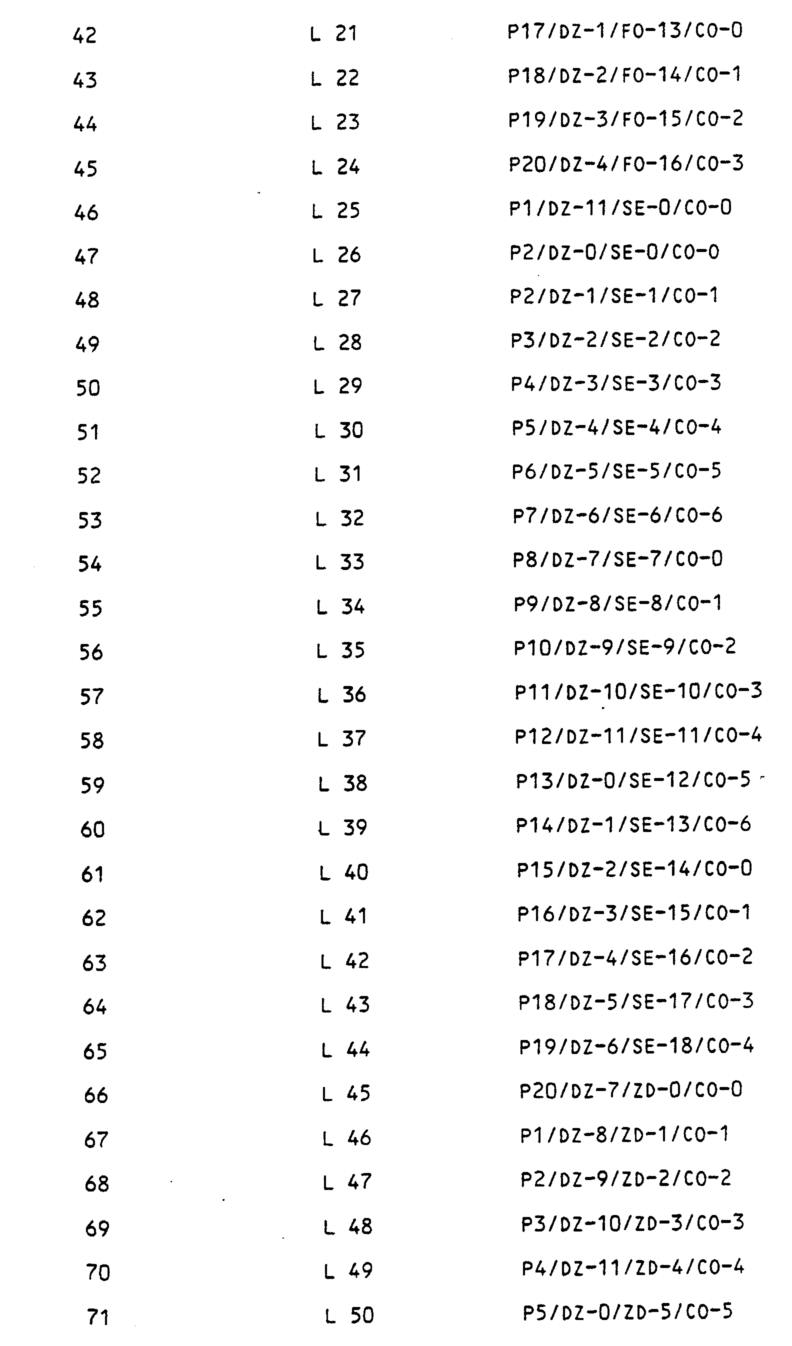

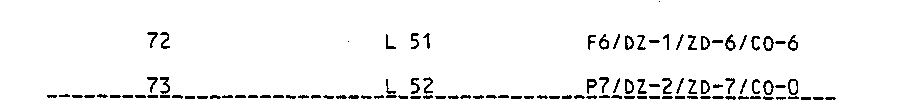

### EXAMPLES 74-125

### Evaluation of the Photosensitive Printing Plates

The photosensitive printing plates L1-L52, prepared as described in Examples 22-74 above, were exposed, developed and evaluated for a number of properties enabling to assess their performances in conditions of actual use.

Plates L1-L52 were exposed keeping constant the following parameters:
- printing plate dimension (77 x 103 cm)
- kind of exposer (Mod. 87 by Lastra Attrezzature)
- exposition time (25 seconds)
- vacuum applied to plate + film during exposition (93%)
- power of the actinic light lamp (2000 Watt)
- emission spectrum of the actinic lamp (360 nanometers)
- distance of the lamp from the exposed surface (70 cm)
- film showing a figure that is superimposed upon the plate.

After exposure, plates L1-L52 were developed keeping constant the following parameters:
- automatic developer with a bath at 20°C (SM 140 by Lastra Attrezzature)
- developer (aqueous-alkaline at pH = 10.0)

Developed printing plates were evaluated for the following properties:
A = developing rate (cm/min) at a temperature of 20°C.
   Data were evaluated on a scale ranging from 1 to 6, where 1 is the worst and 6 the best value.
B = cleanliness of the non printing portions
   The dimensions (in microns) of the remaining particles of layer not removed by the developing solution and their quantity (number per square centimeter) were evaluated by means of a stereo microscope at 40 magnifications.
   On all plates L1-L52 no residual particle was detected, therefore this characteristic was deemed excellent for all the plates and is not shown in Table III that summarizes the plates evaluation.
C = inking degree on a "Stouffer" scale (21 steps) when the printing plate inked by a rubber roller retains an amount of ink of 3 microns on its surface. The values are evaluated on a scale ranging from 1 to 21, where 1 is the worst and 21 the best value.
D = cleanliness of the non-printing portions after inking
   The ink should not stain at all the non-printing portions of the plate. The values are evaluated on a scale ranging from 0 to 10, where 0 is the worst and 10 the best value. All the plates L1-L52 had value 10, therefore this characteristic was deemed excellent for all the plates and is not shown in Table III.
E = ink retention by the printing plate
   A plate uniformly inked with an amount of litographic ink corresponding to 3 micron of thickness, should not deink when immersed for 5 minutes in an aqueous solution of organic and inorganic compounds containing surfactants and having a pH of 4.5 at 20-23°C (Dynafount R 21 by P.C.O.Holland). Deinking is evaluated on a Stouffer Scale 1-21. The number of steps inked before and after the immersion should be the same.
   The values are evaluated on a scale ranging from 1 to 21 where 1 is the worst and 21 the best value.
F = abrasion resistance before inking
   At 25°C, a 23 x 10 cm plate portion, previously weighed on a precision balance, is placed on the surface of an electromechanical abrasimeter. The abrasion was performed with a metal plug weighing 1700 grams provided with a standard abrasive removable surface which was renewed for each sample. The plate surface was submitted to abrasion for 60 cycles at the rate of 1 cycle per second; the plate was weighed after the treatment and the percent weigh loss was calculated.
   The percent abrasion is given as percent weigh loss and the better it is, the lower is the measured value.
G = plate wear while printing
   A test was carried out on a sample of photosensitive plate on which several Stouffer scales were impressed (at the edges - in the center and at the middle portions of the plate). To this purpose the plate was mounted on a printing machine for continuos modules, with standard ink, standard fountain solution, standard paper. Printing was performed at the rate of 20,000 copies per hour, for 5 hours, and both the wear of the inked Stouffer scales after printing and the scale image on printed paper were evaluated.
   Each non-inked and/or non-printed scale step corresponds to a printing wear of 5%.
   The lower is the plate wear while printing, the lower is the percent measured value.

Complete evaluation of plates L1-L52, for the above mentionedproperties, is shown in the following

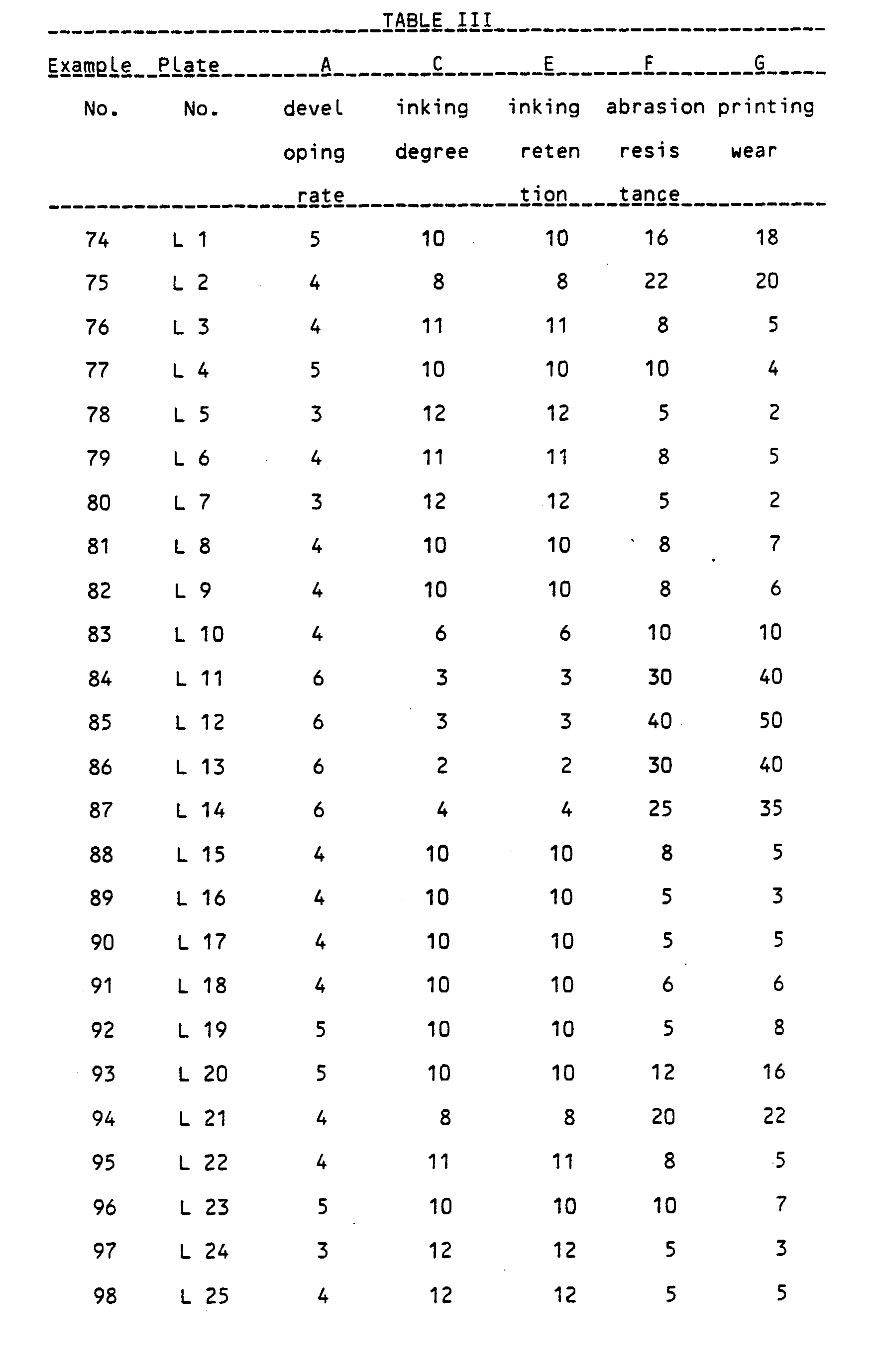

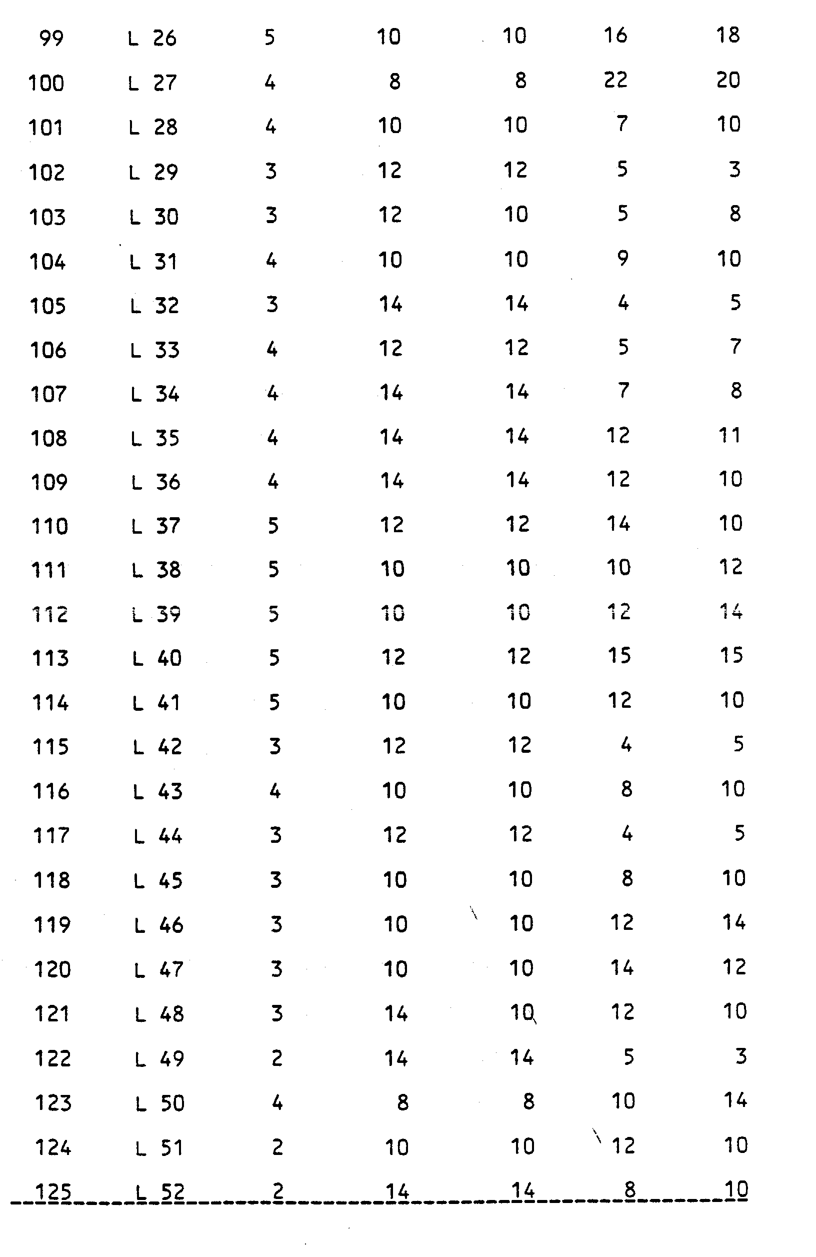

## Claims

1. A compound of the formula 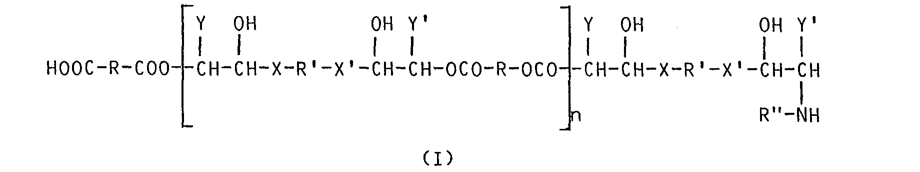 wherein
R is an aliphatic chain having from 2 to 6 carbon atoms and 1 or 2 double bonds;
R' is a covalent bond, a divalent cycloalkyl group having from 5 to 6 carbon atoms, a saturated aliphatic chain having from 2 to 10 carbon atoms and 2 or 4 oxygen atoms which are part of -CO-O- groups, a saturated aliphatic chain having from 2 to 10 carbon atoms and 1 or 2 oxygen atoms of ether groups, a divalent saturated heterocyclic ring having from 3 to 4 carbon atoms and 2 oxygen atoms, a group of the formula 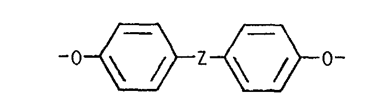 where
Z is SO₂, a saturated straight or branched alkyl chain having from 1 to 3 carbon atoms or an alkylidenephenyl group where the alkylidene moiety is saturated, straight or branched and has 1 to 3 carbon atoms;
R" is a group of the formula 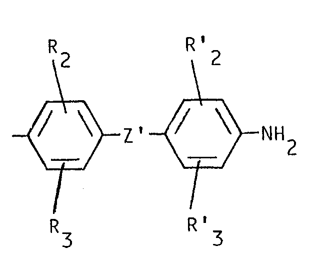 wherein
Z' is a covalent bond, O, S, CH₂, CO, NH, SO₂, SO₂NH, CH₂=CH₂, N=N, NHCONH, NHCSNH or 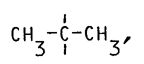 and
R₂, R'₂, R₃, and R'₃, the same or different, are H, CH₃, OCH₃, OC₂H₅, Cl, SO₃H or CH₂-O-CH₃;
Y and Y', the same or different, are hydrogen or, together with X and X', respectively, complete a cycloaliphatic ring having from 5 to 6 carbon atoms; and
X and X' are CH₂ or, the same or different, are a covalent bond when Y and Y' respectively, are hydrogen or, together with Y and Y', respectively, complete a cycloaliphatic ring having from 5 to 6 carbon atoms; and
n is an integer from 2 to 60.

2. A compound according to claim 1, characterized in that R is -CH=CH-CH=CH-, -CH₂-CH=CH-CH₂-, 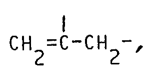 -CH=CH- or -CH=C(CH₃)-.

3. A compound according to any one of claims 1 and 2, characterized in that R' is a covalent bond, -COOCH₂, 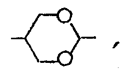 CH₂-OCO-C₄H₈-COO-CH₂-, or 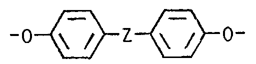 where Z is 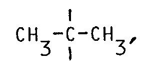 SO₂, CH₂, or

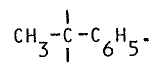

4. A compound according to any one of claims from 1 to 3, characterized in that it has a weight avarage molecular weight value of from 1,200 to 33,000.

5. A compound according to any one of claims from 1 to 4, characterized in that it has an amine number of from 1 to 27.

6. A compound according to any one of claims from 1 to 5, characterized in that it has an unsaturation equivalent of from 400 to 560.

7. A process for preparing a compound of the formula (I) according to claim 1, characterized in that (i) an unsaturated polyhydroxypolyester (II) having an epoxy end group is prepared and (ii) the epoxy end group of the thus obtained unsaturated polyhydroxypolyester (II) is condensed with an amino group of a suitable aromatic diamine according to the following scheme: 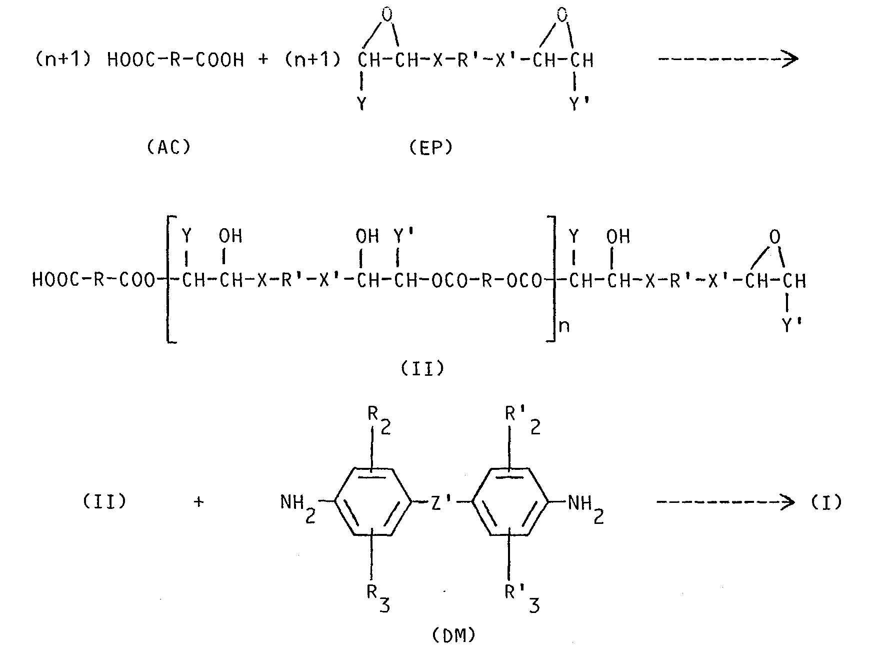 where n,R,Y,X,R',Z',R₂,R'₂,R₃,R'₃, have the meanings mentioned in claim 1.

8. A process according to claim 7, characterized in that (AC) is selected from the group of the aliphatic bicarboxylic acids comprising maleic, fumaric, muconic, hydromuconic, itaconic, citraconic and mesaconic.

9. A process according to any one of claims 7 and 8, characterized in that (EP) is selected from the group of the diepoxidescomprising vinyl cyclohexene dioxide, 3,4-epoxycyclohexylmethyl-3,4-epoxy-cyclohexane-carboxylate, 2-(3,4-epoxycyclohexyl-5,5-spiro-3,4-epoxy)-cyclohexane-metadioxane, bis(3,4-epoxycyclohexyl)-adipate, and diglycidyl ethers of bisphenol A, S, ACP, and F.

10. A process according to any one of claims from 7 to 9, characterized in that the preparation of the unsaturated polylhydroxy polyester (ii) is carried out by reacting substantially equimolar amounts of (AC) and (EP) in the presence of a suitable accelerating agent at a temperature of from 10 to 150°C, optionally in the presence of one or more suitable inert solvents, until the acid number of the intermediate product (II) reaches the theoretical value calculated for the desired molecular weight.

11. A process according to any one of claims from 7 to 10, characterized in that the accelerating agent is selected from the group comprising p-toluensulphonic acid, triphenylphosphine, and trimethylammonium bromide.

12. A process according to any one of claims from 7 to 11, characterized in that the solvent is selected from the group comprising butyl acetate, methyl cellosolve, phenyl cellosolve, ethylene glycol dimethyl ether and ethyl acetate.

13. A process according to any one of claims from 7 to 12, characterized in that the second reaction step comprising the addition of an aromatic diamine (DM) to the unsaturated polyhydroxy polyester (II) is performed by adding to the reaction mixture resulting from the first step an amount of the aromatic diamine (DM) substantially sufficient to react with the epoxy end groups of the unsaturated polyhydroxy polyester (II) at a temperature of from 50 to 150°C.

14. A process according to claim 13, characterized in that the solvents are not removed and antioxidant agents are added at the end of the reaction.

15. A process according to claim 14, characterized in that the antioxidant agents are selected from the group comprising hydroquinone, 2,6-di-terbutyl-p.cresole, butyraldoxime, 1,5-naphthalenediol, di-hydroxyazobenzene and 2-mercaptobenzothiazole.

16. A presensitized positive or negative offset printing plate formed by a layer, sensitive to the light having wavelength of from 200 to 500 nm, coated on a suitable support, said photosensitive layer comprising essentially a polymer, a photosensitive diazocompound, a dye and a compound selected from photoinitiators, sensitizers, and diazides, characterized in that the polymer is a compound of the formula (I) according to claim 1.

17. A printing plate according to claim 16, characterized in that in the compound of the formula (I) R is -CH=CH-CH=CH-, -CH₂-CH=CH-CH₂-, 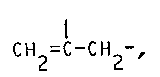 -CH=CH- or -CH=C(CH₃)-.

18. A printing plate according to any one of claims 16 and 17, characterized in that in the compound of the formula (I) R' is a covalent bond, -COOCH₂, 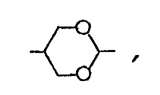 CH₂-OCO-C₄H₈-COO-CH₂-, or 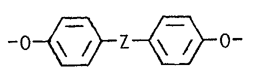 where Z is 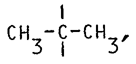 SO₂, CH₂, or

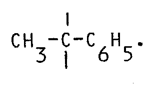

19. A printing plate according to any one of claims from 16 to 18, characterized in that the compound of the formula (I) has a weight average molecular weight value of from 1,200 to 33,000.

20. A printing plate according to any one of claims from 16 to 19, characterized in that the compound of the formula (I) has an amine number of from 1 to 27.

21. A printing plate according to any one of claims from 16 to 20, characterized in that the compound of the formula (I) has an unsaturation equivalent of from 400 to 560.

## Patentansprüche

1. Verbindung der Formel: 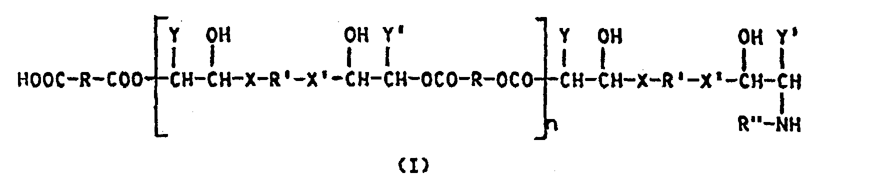 worin R eine aliphatische Kette mit 2 bis 6 Kohlenstoffatomen und 1 oder 2 Doppelbindungen ist;
R' eine kovalente Bindung, eine bivalente CycloalkylGruppe mit 5 bis 6 Kohlenstoffatomen, eine gesättigte aliphatische Kette mit 2 bis 10 Kohlenstoffatomen und 2 oder 4 Sauerstoffatomen, die ein Teil von -CO-O-Gruppen sind, eine gesättigte aliphatische Kette mit 2 bis 10 Kohlenstoffatomen und 1 oder 2 Sauerstoffatomen von Ether-Gruppen, ein bivalenter, gesättigter, heterocyclischer Ring mit 3 bis 4 Kohlenstoffatomen und 2 Sauerstoffatomen, eine Gruppe der Formel ist: 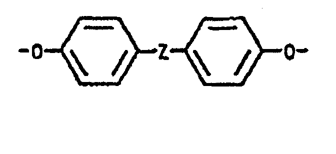 worin Z SO₂, eine gesättigte, geradkettige oder verzweigte Alkyl-Gruppe mit 1 bis 3 Kohlenstoffatomen oder eine Alkylidenphenyl-Gruppe ist, worin der Alkyliden-Anteil gesättigt, geradkettig oder verzweigt ist und 1 bis 3 Kohlenstoffatome hat;
R" eine Gruppe der Formel ist: 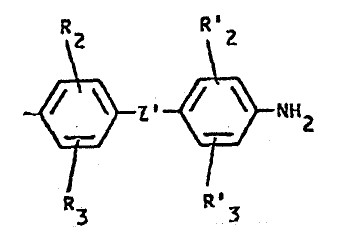 worin Z' eine kovalente Bindung, O, S, CH₂, CO, NH, SO₂, SO₂NH, CH₂=CH₂, N=N, NHCONH, NHCSNH oder 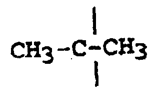 ist, und
R₂, R'₂, R₃ und R'₃ gleich oder verschieden und H, CH₃, OCH₃, OC₂H₅, Cl, SO₃H oder CH₂-O-CH₃ sind;
Y und Y' gleich oder verschieden und Wasserstoff sind oder zusammen mit X bzw. X' einen cycloaliphatischen Ring mit 5 bis 6 Kohlenstoffatomen vervollständigen; und
X und X' CH₂ oder, gleich oder verschieden, eine kovalente Bindung sind, wenn Y bzw. Y' Wasserstoff ist, oder zusammen mit Y bzw. Y' einen cycloaliphatischen Ring mit 5 bis 6 Kohlenstoffatomen vollenden; und
n eine ganze zahl von 2 bis 60 ist.

2. Verbindung nach Anspruch 1, dadurch **gekennzeichnet,** daß R
-CH=CH-CH=CH-, CH₂-CH=CH-CH₂-, 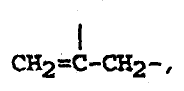 -CH=CH- oder -CH=C(CH₃)- ist.

3. Verbindung nach einem der Ansprüche 1 und 2, dadurch **gekennzeichnet,** daß R' eine kovalente Bindung, -COOCH₂, 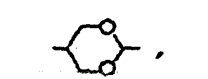 CH₂-OCO-C₄H₈-COO-CH₂- oder 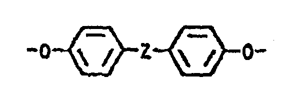 ist, worin Z 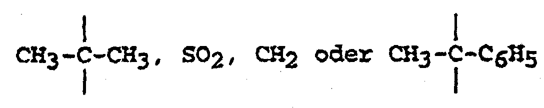 ist.

4. Verbindung nach einem der Ansprüche 1 bis 3, dadurch **gekennzeichnet,** daß sie ein Molekulargewicht im Gewichtsmittel von 1 200 bis 33 000 hat.

5. Verbindung nach einem der Ansprüche 1 bis 4, dadurch **gekennzeichnet,** daß sie eine Aminzahl von 1 bis 27 hat.

6. Verbindung nach einem der Ansprüche 1 bis 5, dadurch **gekennzeichnet,** daß sie ein ungesättigtes Äquivalent von 400 bis 560 hat.

7. Verfahren zur Herstellung einer Verbindung der Formel (I) nach Anspruch 1, dadurch **gekennzeichnet**, daß entsprechend dem folgenden Schema (i) ein ungesättigter Polyhydroxypolyester (II) mit einer Epoxy-Endgruppe hergestellt und (ii) die Epoxy-Endgruppe des somit erhaltenen ungesättigten Polyhydroxypolyesters (II) mit einer Amino-Gruppe eines geeigneten aromatischen Diamins kondensiert wird: : 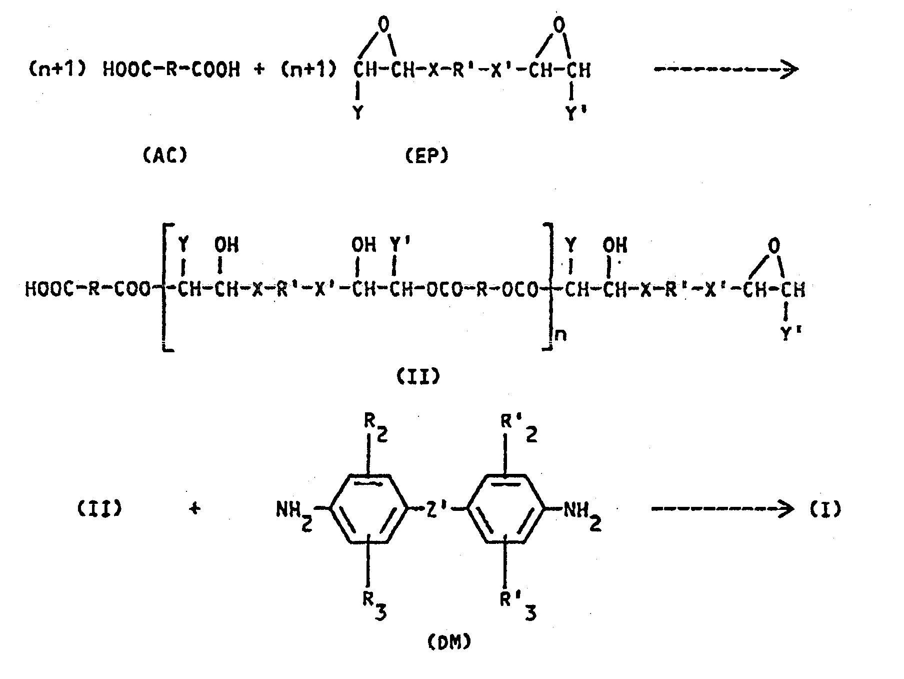 worin n, R, Y, X, R', Z', R₂, R'₂, R₃, R'₃ die in Anspruch 1 erwähnten Bedeutungen haben.

8. Verfahren nach Anspruch 7, dadurch gekennzeichnet, daß (AC) ausgewählt wird aus oder Gruppe der aliphatischen Bicarbonsäuren, umfassend Maleinsäure, Fumarsäure, Muconsäure, Hydromuconsäure, Itaconsäure, Citraconsäure und Mesaconsäure.

9. Verfahren nach einem der Ansprüche 7 und 8, dadurch **gekennzeichnet**, daß (EP) ausgewählt ist aus der Gruppe der Diepoxide, umfassend vinylcyclohexendioxid, 3,4-Epokycyclohexylmethyl-3,4-epoxy-cyclohexancarboxylat, 2-(3,4-Epoxy-cyclohexyl-5,5-spiro-3,4-epoxy)-cyclohexan-metadioxan, Bis(3,4-epoxycyclohexyl)-adipat und Diglycidylether von Bisphenol A, S, ACP und F.

10. Verfahren nach einem der Ansprüche 7 bis 9, dadurch **gekennzeichnet,** daß die Herstellung des ungesättigten Polyhydroxypolyesters (II) durch Reaktion von im wesentlichen äquimolaren Mengen von (AC) und (EP) in der Gegenwart eines geeigneten Beschleunigungsmittels bei einer Temperatur von 10 bis 150°C wahlweise in der Gegenwart von einem oder mehreren geeigneten inerten Lösungsmitteln durchgeführt wird, bis die Säurezahl des zwischenproduktes (II) den theoretischen Wert erreicht, der für das gewünschte Molekulargewicht berechnet ist.

11. Verfahren nach einem der Ansprüche 7 bis 10, dadurch **gekennzeichnet,** daß das Beschleunigungsmittel aus der Gruppe ausgewählt ist, umfassend p-Toluolsulfonsäure, Triphenylphosphin und Trimethylammoniumbromid.

12. Verfahren nach einem der Ansprüche 7 bis 11, dadurch **gekennzeichnet,** daß das Lösungsmittel ausgewählt ist aus der Gruppe, umfassend Butylacetat, Methylcellosolv, Phenylcellosolv, Ethylenglykoldimethylether und Ethylacetat.

13. Verfahren nach einem der Ansprüche 7 bis 12, dadurch **gekennzeichnet,** daß der zweite Reaktionsschritt, umfassend die zugabe eines aromatischen Diamins (DM) zu den ungesättigten Polyhydroxypolyestern (II), durch Zugabe einer Menge des aromatischen Diamins (DM), die im wesentlichen ausreichend ist, um mit den Epoxy-Endgruppen des ungesättigten Polyhydroxypolyesters (II) zu reagieren, zu der Reaktionsmischung, die von dem ersten Schritt resultiert, bei einer Temperatur von 50 bis 150° durchgeführt wird.

14. Verfahren nach Anspruch 13, dadurch **gekennzeichnet**, daß die Lösungsmittel nicht entfernt und Antioxidationsmittel am Ende der Reaktion zugegeben werden.

15. Verfahren nach Anspruch 14, dadurch **gekennzeichnet,** daß die Antioxidationsmittel ausgewählt sind aus der Gruppe, umfassend Hydrochihon, 2,5-Di-tertbutyl-p-cresol, Butyraldoxim, 1,5-Naphthalindiol, Di-hydroxyazobenzol und 2-Mercaptobenzothiazol.

16. Vorsensibilisierte, positive oder negative Offsetdruckplatte, gebildet durch eine Schicht, die für Licht mit einer Wellenlänge von 200 bis 500 nm empfindlich ist, die auf einen,geeigneten Träger geschichtet ist, wobei die lichtempfindliche Schicht im wesentlichen ein Polymer, eine lichtempfindliche Diazo-Verbindung, einen Farbstoff und eine Verbindung enthält, ausgewählt aus Photoinitiatoren, Sensibilisatoren und Diaziden, dadurch **gekennzeichnet,** daß das Polymer eine Verbindung (I) nach Anspruch 1 ist.

17. Druckplatte nach Anspruch 16, dadurch **gekennzeichnet,** daß in der Verbindung der Formel (I) R -CH=CH-CH=CH-, -CH₂-CH=CH=CH₂-, 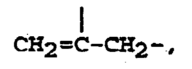 -CH=CH- oder -CH=C(CH₃)- ist.

18. Druckplatte nach einem der Ansprüche 16 und 17, dadurch **gekennzeichnet,** daß in der Verbindung der Formel (I) R' eine kovalente Bindung, -COOCH₂, 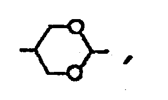 CH₂-OCO-C₄H₈-COO-CH₂- oder 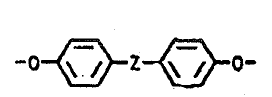 ist, worin Z 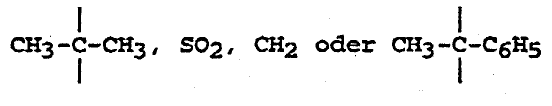 ist.

19. Druckplatte nach einem der Ansprüche 16 bis 18, dadurch **gekennzeichnet,** daß die Verbindung der Formel (I) ein Molekulargewicht im Gewichtsmittel von 1 200 bis 33 000 hat.

20. Druckplatte nach einem der Ansprüche 16 bis 19, dadurch **gekennzeichnet,** daß die Verbindung der Formel (I) eine Aminzahl von 1 bis 27 hat.

21. Druckplatte nach einem der Ansprüche 16 bis 20, dadurch **gekennzeichnet,** daß die Verbindung der Formel (I) ein ungesättigtes Äquivalent von 400 bis 560 hat.

## Revendications

1. Composé de formule 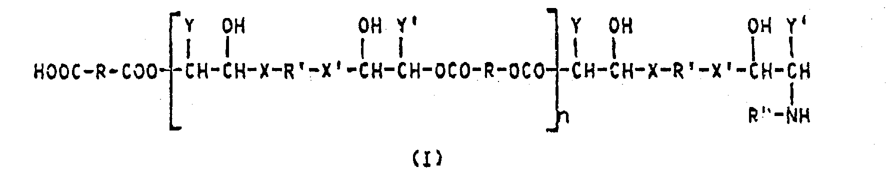 dans laquelle
R représente une chaîne aliphatique contenant de 2 à 6 atomes de carbone et 1 ou 2 doubles liaisons ;
R' représente une liaison covalente, un groupe cycloalkyle contenant de 5 à 6 atomes de carbone, une chaîne aliphatique saturée contenant de 2 à 10 atomes de carbone et de 2 à 4 atomes d'oxygène qui font partie de groupes -CO-O-, une chaîne aliphatique saturée contenant de 2 à 10 atomes de carbone, et 1 ou 2 atomes d'oxygène de groupes éther, un noyau hétérocyclique saturé divalent contenant de 3 à 4 atomes de carbone et 2 atomes d'oxygène, un groupe de formule 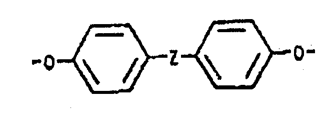 dans laquelle
Z représente SO₂, une chaîne alkyle linéaire ou ramifiée saturée contenant de 1 à 3 atomes de carbone ou un groupe alkylidènephényle dans lequel la partie alkylidène est saturée, linéaire ou ramifiée et contient de 1 à 3 atomes de carbone ; R" représente un groupe de formule 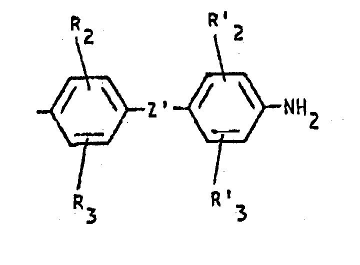 dans laquelle
Z' représente une liaison covalente, O, S, CH₂, CO, NH, SO₂, SO₂NH, CH₂=CH₂, N=N, NHCONH, NHCSNH ou 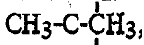 et
R₂, R'₂, R₃ et R'₃, identiques ou différents, représentent H, CH₃, OCH₃, OC₂H₅, Cl, SO₃H ou CH₂-O-CH₃ ;
Y et Y', identiques ou différents, représentent un atome d'hydrogène ou, pas avec X et X', complètent, respectivement, un noyau cycloaliphatique contenant de 5 à 6 atomes de carbone ; et
X et X' représentent CH₂, ou, identiques ou différents, représentent une liaison covalente lorsque Y et Y' représentent respectivement un atome d'hydrogène, ou pris avec Y et Y', complètent respectivement un noyau cycloaliphatique contenant de 5 à 6 atomes de carbone ; et
n est un nombre entier compris entre 2 et 60.

2. Composé conforme à la revendication 1, caractérisé en ce que R représente -CH=CH-CH=CH-, -CH₂-CH=CH-CH₂-, 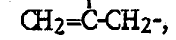 -CH=CH- ou -CH=C(CH₃)-.

3. Composé conforme à l'une quelconque des revendications 1 et 2, caractérisé en ce que R' représente une liaison covalente, 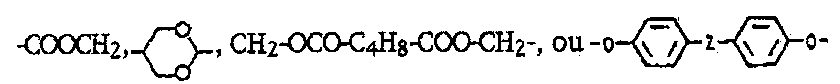 où Z représente

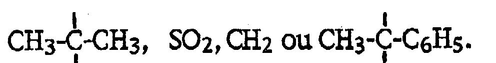

4. Composé conformé à l'une quelconque des revendications 1 à 3, caractérisé en ce que sa valeur de poids moléculaire moyen en poids, est comprise entre 1 200 et 33 000.

5. Composé conforme à l'une quelconque des revendications 1 à 4, caractérisé en qu'il a un nombre de groupe amine compris, entre 1 et 27.

6. Composé conforme à l'une quelconque des revendications 1 à 5, caractérisé en ce qu'il a un équivalent d'insaturation compris entre 400 et 560.

7. Procédé de préparation d'un composé de formule (I) conforme à la revendication 1, caractérisé en ce que (i) on prépare un polyhydroxypolyester (II) ayant un groupe final époxy et (ii) on condense le groupe final époxy du polyhydroxypolyester (II) insaturé ainsi obtenu avec un groupe amino d'une diamine aromatique appropriée conformément au schéma suivant : 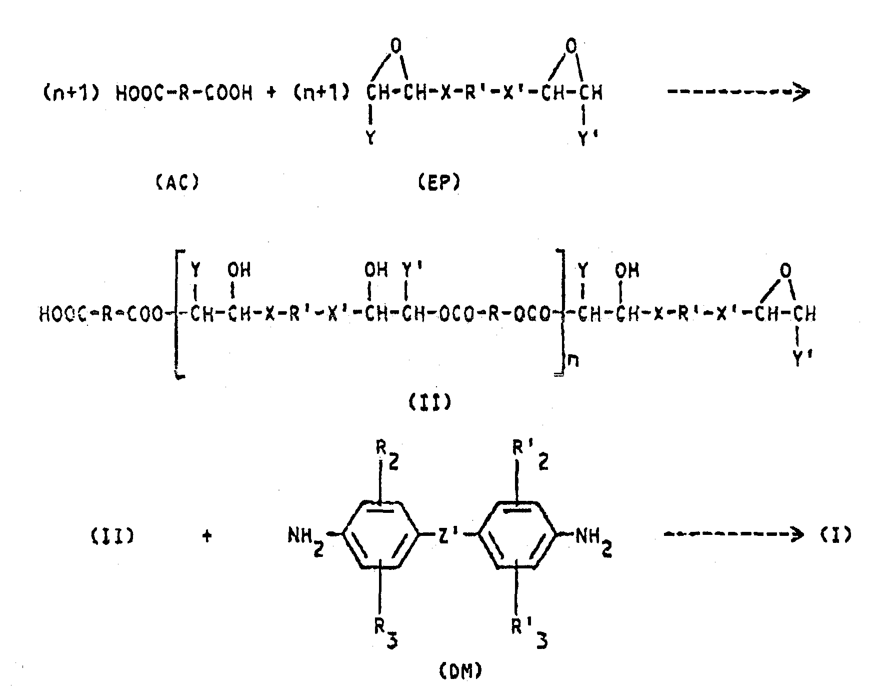 dans lesquels n, R, Y, X, R', Z',R₂, R'₂, R₃, R'₃ ont les significations mentionnées dans la revendication 1.

8. Procédé conforme à la revendication 7, caractérisé en ce que (AC) est choisi dans l'ensemble des acides bicarboxyliques aliphatiques, comprenant les acides maléique, fumarique, muconique, hydromuconique, itaconique, citraconique et mésaconique.

9. Procédé conforme à l'une quelconque des revendications 7 et 8, caractérisé en ce que (EP) est choisi dans l'ensemble des diépoxydes constitué des dioxyde de vinylcyclohexène, 3,4-époxycyclohexylméthyl-3,4,époxy-cydohexane-carboxylate, 2-(3,4-époxycyclohexyl-5,5-spiro-3,4-époxy)-cyclohexanemétadioxane, bis(3,4-époxycyclohexyl)-adipate, et éthers diglyciyliques de bisphénol A, S, ACP et F.

10. Procédé conforme à l'une quelconque des revendications 7 à 9, caractérisé en ce que la préparation du polyhydroxypolyester (II) est effectuée en faisant réagir des quantités pratiquement équimolaires de (AC) et de (EP) en présence d'un agent d'accélération approprié à une température comprise entre 10 et 150°C, éventuellement en présence d'un ou plusieurs solvants inertes appropriés, jusqu'à ce que le nombre acide du produit intermédiaire (II) atteigne la valeur théorique calculée pour le poids moléculaire désiré.

11. Procédé conforme à l'une quelconque des revendications 7 à 10, caractérisé en ce que l'agent d'accélération est choisi dans l'ensemble constitué de l'acide p-toluènesulfonique, de la triphénylphosphine et du bromure de triméthylammonium.

12. Procédé conforme à l'une quelconque des revendications 7 à 11, caractérisé en ce que le solvant est choisi dans l'ensemble comprenant les acétate de butyle, méthylcellosolve, phénylcellosolve, éther diméthylique d'éthyléneglycol et acétate d'éthyle.

13. Procédé conforme à l'une quelconque des revendications 7 à 12, caractérisé en ce que la seconde étape de réaction comprenant l'addition d'une diamine aromatique (DM) au polyhydroxypolyester insaturé (II) est effectuée par l'addition au mélange réactionnel résultant de la première étape d'une quantité de diamine aromatique (DM) pratiquement suffisante pour réagir avec les groupes époxy terminaux du polyhydroxypolyester insaturé (II) à une température comprise entre 50 et 150°C.

14. Procédé conforme à la revendication 13, caractérisé en ce que les solvants ne sont pas éliminés et les agents antioxydants sont ajoutés à la fin de la réaction.

15. Procédé conforme à la revendication 14, caractérisé en ce que les agents antioxydants sont choisis dans l'ensemble constitué des hydroquinone, 2,6-di-terbutyl-p.crésole, butyraldoxime, 1,5-naphtalènediol, dihydroxyazobenzène et 2-mercaptobenzothiazole.

16. Plaque d'impression offset positive ou négative présensibilisée formée d'une couche, sensible à la lumière de longueurs d'onde comprises entre 200 et 500 mm, déposée sur un support approprié, ladite plaque photosensible étant essentiellement constituée d'un polymère, d'un composé diazo photosensible, d'un colorant et d'un composé choisi parmi les photoémetteurs, sensibilisateurs et diazotures, caractérisé en ce que le polymère est un composé de formule (I) conforme à la revendication 1.

17. Plaque d'impression conforme à la revendication 16, caractérisé en ce que, dans le composé de formule, (I), R représente -CH=CH-CH=CH-, CH₂-CH=-CH-CH₂-, 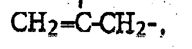 CH=CH- ou -CH=C(CH₃)-.

18. Plaque d'impression conforme aux revendications 16 et 17, caractérisé en ce que, dans le composé de formule (I), R' représente une liaison covalente, -COOCH₂, 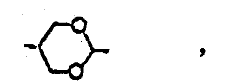 -CH₂-OCO-C₄H₈-COO-CH₂-, ou 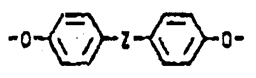 où Z représente

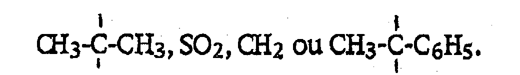

19. Plaque d'impression conforme, à l'une quelconque des revendications 16 à 18, caractérisée en ce que le composé de formule (I) a une valeur de poids moléculaire moyen en poids compris entre 1 200 et 33 000.

20. Plaque d'impression conforme à l'une quelconque des revendications 16 à 19, caractérisée en ce que le composé de formule (I) a un nombre de groupes amine compris entre 1 et 27.

21. Plaque d'impression conforme à l'une quelconque des revendications 16 à 20, caractérisée en ce que le composé de formule (I) a un équivalent d'insaturation compris entre 400 et 560.
